**Europäisches Patentamt**

**European Patent Office**

**Office européen des brevets**

(11) Veröffentlichungsnummer: **0 411 201 A1**

# EUROPÄISCHE PATENTANMELDUNG

(21) Anmeldenummer: **89114468.5**

(22) Anmeldetag: **04.08.89**

(51) Int. Cl.⁵: **G11C 5/14**, G11C 11/407, G05F 3/24

(43) Veröffentlichungstag der Anmeldung:
**06.02.91 Patentblatt 91/06**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Nikutta, Wolfgang, Dipl.-Phys.**
**Werinherstrasse 101**
**D-8000 München 90(DE)**

(54) **Potentialgenerator in einer integrierten Halbleiterschaltung.**

(57) Der Potentialgenerator in einer integrierten Halbleiterschaltung enthält eine Generatorschaltung VGen zur Erzeugung zweier Referenzpotentiale V+,V- mit unterschiedlich hohen Werten. Der Generatorschaltung VGen ist eine Regleranordnung Reg nachgeschaltet. Dieser wiederum ist eine Treiberschaltung DVR nachgeschaltet, an deren Ausgang im Betrieb ein geregeltes Ausgangspotential VReg entsteht als Ausgangspotential des Potentialgenerators. Der Wert des Ausgangspotentials VReg liegt im geregelten Zustand zwischen den Werten der Referenzpotentiale V+,V-.

FIG 1

# POTENTIALGENERATOR IN EINER INTEGRIERTEN HALBLEITERSCHALTUNG

Die Erfindung betrifft einen Potentialgenerator in einer integrierten Halbleiterschaltung.

In integrierten Halbleiterschaltungen werden häufig elektrische Potentiale benötigt, die ungleich den Versorgungspotentialen der Halbleiterschaltung sind. Beispielsweise ist bei bestimmten integrierten Halbleiterspeichern mit 1-Transistor-Speicherzellen eine Platte jedes Speicherkondensators der Speicherzellen mit einem Potential verbunden, das zwischen den beiden Versorgungspotentialen des Halbleiterspeichers liegt. Außerdem werden zu Auslese- und Bewertungszwecken die Bitleitungen eines solchen Halbleiterspeichers vor dem Auslesen auf ein Potential vorgeladen, das zwischen den Versorgungspotentialen liegt (sog. Mid-Level-Bewertung). Um Anschlußpins einzusparen, werden benötigte Potentiale, die wertemäßig ungleich den Versorgungspotentialen sind, meist "on chip" mittels Potentialgeneratoren erzeugt.

Aufgabe der vorliegenden Erfindung ist es, einen Potentialgenerator in einer integrierten Halbleiterschaltung zu schaffen, der bei Erreichen des gewünschten Potentials an seinem Ausgang einen möglichst geringen Querstrom zwischen den Versorgungspotentialen der Halbleiterschaltung aufweist.

Diese Aufgabe wird gelöst durch einen Potentialgenerator mit den Merkmalen des Patentanspruches 1. Vorteilhafte Aus- und Weiterbildungen sind in Unteransprüchen gekennzeichnet.

Die Erfindung wird nachstehend anhand von FIG näher erläutert. Es zeigen:

FIG 1 den erfindungsgemäßen Potentialgenerator,

FIG 2 vorteilhafte Teilschaltungen desselben,

FIG 3 eine weitere vorteilhafte Ausführungsform.

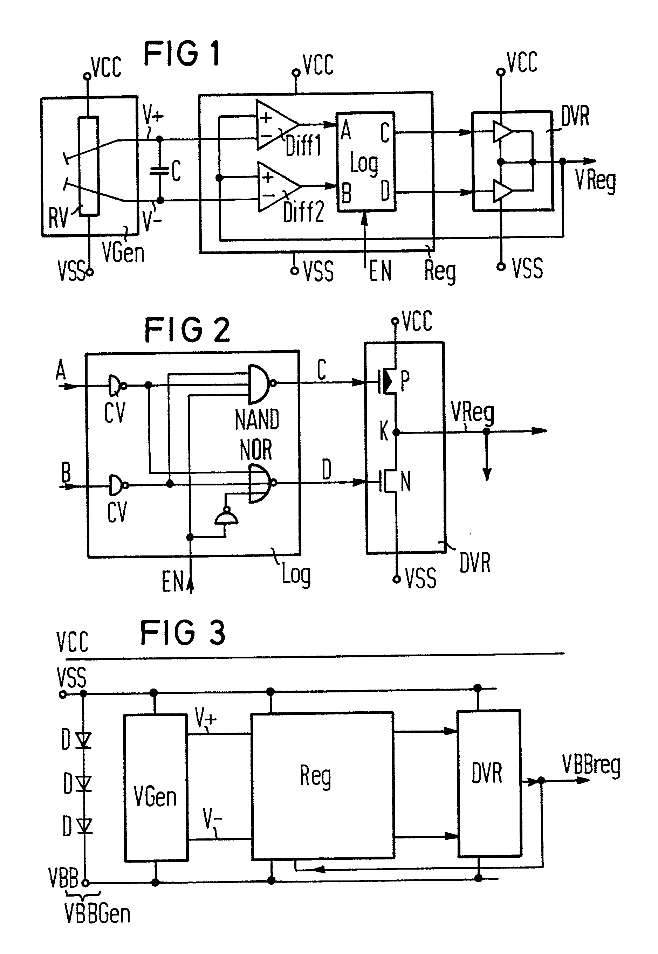

Gemäß FIG 1 enthält der erfindungsgemäße Potentialgenerator eine Generatorschaltung VGen zur Erzeugung zweier Referenzpotentiale V+,V-. Die Referenzpotentiale V+,V- weisen unterschiedlich hohe Pegelwerte auf. Der Generatorschaltung VGen ist eine Regleranordnung Reg nachgeschaltet. Dieser wiederum ist eine Treiberschaltung DVR nachgeschaltet. In Betrieb liegt am Ausgang der Treiberschaltung DVR ein geregeltes Ausgangspotential VReg an, das das durch den Potentialgenerator zu erzeugende Potential ist. Der Wert des Ausgangspotentials VReg im geregelten Zustand liegt im Bereich zwischen den Werten der Referenzpotentiale V+,V-. Es ist günstig, wenn die Differenz zwischen den Pegelwerten der Referenzpotentiale V+,V- 50 bis 500 mV beträgt. Ist die Differenz kleiner als 50 mV, so würde die Regleranordnung Reg sehr häufig nachregeln, was zu einem erhöhten Stromverbrauch führt. Ist die Differenz größer als 500 mV, so ist das Ausgangspotential VReg unerwünscht hohen Schwankungen unterworfen. Es ist weiterhin vorteilhaft, wenn im geregelten Zustand die Treiberschaltung DVR elektrisch inaktiv geschaltet ist. Dann weist nämlich die Treiberschaltung DVR, und somit der gesamte Potentialgenerator, einen minimalen Stromverbrauch auf. Es ist weiterhin günstig, wenn die Generatorschaltung VGen, wie in FIG 1 gezeigt, wenigstens eine Spannungsteilerschaltung RV enthält. Nach FIG 1 ist dies ein Widerstand mit zwei Potentialabgriffen, an denen die Referenzpotentiale V+,V- abgreifbar sind. Die Generatorschaltung VGen weist somit für jedes Referenzpotential V+,V- einen eigenen Ausgang auf. Eine Realisierung mit zwei verschiedenen Spannungsteilerschaltungen RV ist jedoch ebenfalls möglich.

Es ist auch vorteilhaft, wenn zwischen den beiden Ausgängen für die Referenzpotentiale V+,V- eine Kapazität C angeordnet ist, beispielsweise in der Größenordnung von 300 fF. Sollten im Betrieb nämlich Störungen auftreten (was bekanntlich nie ganz auszuschließen ist), so kann es unter ungünstigen Umständen geschehen, daß die Störungen die Werte der Referenzpotentiale V+,V- so verändern, daß sich die zwischen den beiden Referenzpotentialen V+,V- bestehende Potentialdifferenz vorzeichenmäßig umkehrt, was die Funktion des Potentialgenerators negativ beeinflußt. Die Kapazität C verhindert dies zuverlässig.

Gemäß der Ausführungsform nach FIG 1 enthält die Regleranordnung Reg zwei Differenzverstärker Diff1,Diff2, denen gemeinsam eine Logikschaltung Log nachgeschaltet ist. Bekanntlich weist ein Differenzverstärker (wenigstens) zwei Eingänge auf. Der erste Eingang ("-") des einen Differenzverstärkers Diff1 ist mit dem einen Referenzpotential V+ verbunden. Der erste Eingang ("-") des anderen Differenzverstärkers Diff2 ist mit dem anderen Referenzpotential V- verbunden. Die zweiten Eingänge ("+") der Differenzverstärker Diff1,Diff2 sind mit dem Ausgangspotential VReg des Potentialgenerators verbunden (Rückkopplung).

Ein erster Steuereingang A der Logikschaltung Log ist mit dem Ausgang des einen Differenzverstärkers Diff1 verbunden. Ein zweiter Steuereingang B der Logikschaltung Log ist mit dem Ausgang des anderen Differenzverstärkers Diff2 verbunden. Zwei Ausgänge C,D der Logikschaltung Log sind mit Eingängen der Treiberschaltung DVR verbunden.

In einer besonderen Ausführungsform, dargestellt ebenfalls in FIG 1, ist der Logikschaltung Log im Betrieb weiterhin ein Enable-Signal EN zuführbar, mittels dessen beide Ausgänge C,D der Logikschaltung Log unabhängig vom aktuellen Wert des Ausgangspotentials VReg deaktivierbar sind. Dies hat folgenden Vorteil: Bei integrierten DRAM-Halbleiterspeichern ist es im Lesebetrieb während der Bewertungsphase (d.h. nach Auslesen der Informationen aus einer Speicherzelle) notwendig, daß die an die Bewerterschaltung angeschlossenen, die ausgelesene Information enthaltenden Bitleitungen möglichst keinem Fremdeinfluß ausgesetzt sind, damit auch kleine Lesesignale genau bewertbar sind. Würde nun genau in der Bewertungsphase ein Nachregeln des an die Bitleitungen angeschlossenen Ausgangspotentials VReg erfolgen, so könnte dies die Bewertung ungünstig beeinflussen. Mittels des Enable-Signals EN ist dies jedoch zuverlässig ausschließbar.

Eine besondere Ausführungsform der Logikschaltung Log ist in FIG 2 dargestellt: Sie enthält ein NAND-Gatter NAND, dessen Ausgang der eine Ausgang C der Logikschaltung Log ist. Sie enthält weiterhin ein NOR-Gatter NOR, dessen Ausgang der andere Ausgang D der Logikschaltung Log ist. Beide Gatter NAND,NOR sind eingangsmäßig mit den Steuereingängen A,B der Logikschaltung Log verbunden. Dabei ist es vorteilhaft, wie ebenfalls dargestellt, wenn zwischen den Steuereingängen A,B und den Gattereingängen jeweils ein Pegelkonverter CV angeordnet ist. In FIG 2 ist als Pegelkonverter CV ein Inverter gewählt. Damit ist gewährleistet, daß selbst in dem Fall an den Gattereingängen Signale mit günstigen Pegelwerten anliegen, in dem die Regleranordnung Reg im Betrieb Signale für die Steuereingänge A,B liefert mit ungünstigen Pegelwerten bezüglich geforderter Pegelwerte für die Gattereingänge.

Das NAND-Gatter NAND ist eingangsmäßig auch mit dem Enable-Signal EN verbunden. Das NOR-Gatter NOR ist eingangsmäßig außerdem mit einem gegenüber dem Enable-Signal EN invertierten Signal verbunden. Damit ergeben sich im Betrieb an den Ausgängen C,D der Logikschaltung Log folgende logische Zustände: Ist das Enable-Signal EN in seinem elektrisch inaktiv wirkenden Zustand, so ist der eine Ausgang C auf einem hohen Potential, was für die nachgeschaltete Treiberschaltung DVR "inaktiv" bedeute. Weiterhin ist in diesem Fall der andere Ausgang D auf einem niedrigen Potential, was für die nachgeschaltete Treiberschaltung DVR ebenfalls "inaktiv" bedeute. Die Treiberschaltung DVR ist somit auf jeden Fall inaktiv geschaltet, unabhängig vom Zustand der Steuereingänge A,B.

Ist das Enable-Signal EN jedoch in seinem elektrisch aktiv wirkenden Zustand, so sind folgende drei Fälle möglich:

a) Das Ausgangspotential VReg ist niedriger als das niedrigere (V-) der beiden Referenzpotentiale V + ,V-,

b) das Ausgangspotential VReg liegt wertemäßig zwischen den Werten der beiden Referenzpotentiale V + ,V-,

c) das Ausgangspotential VReg ist höher als das höhere (V + ) der beiden Referenzpotentiale V + ,V-.

Im Falle b), der dem geregelten Soll-Zustand des Ausgangspotentials VReg entspricht, soll die Treiberschaltung DVR inaktiv sein, wie bereits beschrieben (möglichst niedriger Stromverbrauch). In diesem Fall weist der eine Ausgang C der Logikschaltung Log aufgrund seiner Anpassung an das Schaltverhalten der Treiberschaltung DVR (wird noch beschrieben) einen hohen Pegel auf. Entsprechend weist das andere Ausgangssignal D einen niedrigen Pegel auf. Im Falle a) ist das Ausgangspotential VReg nachzuregeln, bis es den Wert des einen, niedrigeren Referenzpotentials V- annimmt. Dazu weisen beide Ausgänge C,D ein niedriges Potential auf. Im Falle c) ist das Ausgangspotential VReg nachzurgegeln, bis es den Wert des anderen höheren Referenzpotentials V + annimmt. Dazu weisen beide Ausgänge C,D ein hohes Potential auf.

Verwendet man unter Beibehaltung dieser logischen Bedingungen anstelle der gezeigten Inverter als Pegelkonverter CV nicht-invertierende Elemente oder verwendet man überhaupt keine Pegelkonverter CV, so sind das NAND-Gatter NAND durch ein OR-Gatter zu ersetzen und das NOR-Gatter NOR durch ein AND-Gatter. Weiterhin ist bei Verwendung des Enable-Signals EN dieses dem AND-Gatter direkt zuzuführen, während das OR-Gatter mit einem gegenüber dem Enable-Signal EN invertierten Signal zu verbinden ist.

FIG 2 zeigt auch eine vorteilhafte Ausführungsform der Treiberschaltung DVR. Sie enthält wenigstens zwei Transistoren P,N, die in Serie zueinander zwischen zwei Versorgungspotentiale VCC, VSS der integrierten Halbleiterschaltung geschaltet sind. Sie bilden dabei einen gemeinsamen Schaltungsknoten K. Im Betrieb entsteht an diesem das geregelte Ausgangspotential VReg des Potentialgenerators, welches außerdem, wie bereits erläutert, auf die Regleranordnung Reg rückgekoppelt ist. Das Gate des einen Transistors P ist mit dem einen Ausgang C der Logikschaltung Log verbunden. Das Gate des anderen Transistors N ist mit dem anderen Ausgang D der Logikschaltung Log verbunden. Die beiden Transistoren P,N sind vorzugsweise vom einander entgegengesetzten Leitungstyp. Damit ist ein Spannungsverlust in Höhe des Wertes der Einsatzspannung $V_T$ jedes Transistors vermeidbar beim Durchschalten der Transistoren. In FIG 2 ist der eine Transistor P vom p-Kanal-Typ. Der andere Transistor N ist vom n-Kanal-Typ.

Das Schaltverhalten der Treiberschaltung DVR wird nun anhand der obengenannten Fälle a),b),c) näher erläutert:

Im Falle b), der dem Soll-Zustand entspricht, weist der eine Ausgang C der Logikschaltung Log einen hohen Wert auf, während der andere Ausgang D der Logikschaltung Log einen niedrigen Wert aufweist (als "hoher Wert" wird ein Wert angenommen, der dem einen Versorgungspotential VCC entspricht (typischerweise 5V); als "niedriger Wert" wird ein Wert angenommen, der dem anderen Versorgungspotential VSS entspricht (typischerweise 0V)). Demzufolge sind beide Transistoren P,N gesperrt.

In dem Fall, in dem (unabhängig von den Fällen a),b),c)) das Enable-Signal EN seinen inaktiven Zustand aufweist, herrschen bei der Treiberschaltung DVR dieselben Potential- und Logikverhältnisse wie im oben beschriebenen Fall b).

Im Falle a) soll das Ausgangspotential VReg in Richtung des einen Versorgungspotentials VCC gezogen werden, bis es den Wert des einen Referenzpotentials V- erreicht. Dazu weisen, wie bereits erläutert, beide Ausgänge C,D ein niedriges Potential auf. Demzufolge sind der eine Transistor P leitend und der andere Transistor N gesperrt. Dieser Zustand dauert an, bis das Ausgangspotential VReg den Wert des einen Referenzpotentials V-erreicht und demzufolge wegen der Rückkopplung des Ausgangspo tentials VReg der eine Differenzverstärker Diff1 dies erkennt und seinen Zustand ändert.

Im Falle c) soll das Ausgangspotential VReg in Richtung des anderen Versorgungspotentials VSS gezogen werden, bis es den Wert des anderen Referenzpotentials V + erreicht. Dazu weisen, wie bereits erläutert, beide Ausgänge C,D ein hohes Potential auf. Demzufolge sind der eine Transistor P gesperrt und der andere Transistor N leitend. Dieser Zustand dauert an, bis das Ausgangspotential VReg den Wert des anderen Referenzpotentials V + erreicht und demzufolge wegen der Rückkopplung des Ausgangspotentials VReg der andere Differenzverstärker Diff2 dies erkennt und seinen Zustand ändert.

Die vorstehend beschriebenen Potentialpegel der Ausgänge C,D lassen sich tabellarisch folgendermaßen darstellen:

|              | Fall a)       | Fall b)            | Fall c)     |
| ------------ | ------------- | ------------------ | ----------- |
| EN aktiv     | C,D: niedrig  | C: hoch, D: niedrig | C,D: hoch   |
| EN inaktiv   | C: hoch       |                    | D: niedrig  |

Die obige Erfindung wurde bislang anhand der Prämisse erläutert, daß das geregelte Ausgangspotential VReg im geregelten Zustand einen Wert zwischen den beiden Versorgungspotentialen VCC,VSS der integrierten Halbleiterschaltung aufweisen soll. Es ist jedoch auch möglich, den Potentialgenerator so auszulegen, daß der Wert des Ausgangspotentials VReg außerhalb des durch die Versorgungspotentiale VCC,VSS definierten Bereiches liegt. Die Erfindung ist beispielsweise auch anwendbar zur Erzeugung eines geregelten Substratvorspannungspotentials VBBreg auf dem Halbleiterchip der integrierten Halbleiterschaltung. Wie in FIG 3 gezeigt, enthält die integrierte Halbleiterschaltung in diesem Fall zunächst einen Substratvorspannungsgenerator VBBGen zur "On chip" Erzeugung eines (ungeregelten) Substratvorspannungspotentials VBB. Substratvorspannungsgeneratoren als solche sind bekannt. Sie sind im allgemeinen als passiv wirkende Ladungspumpen ausgelegt, d.h. sie erzeugen ein vorgegebenes, vom Wert der Versorgungspotentiale VCC,VSS bestimmtes Substratvorspannungspotential VBB. Bei plötzlicher Erniedrigung des Wertes des einen Versorgungspotentials VCC soll sich bekanntlich der Wert des Substratvorspannungspotentials VBB in Richtung des anderen Versorgungspotentials VSS ändern. Bei den bekannten Substratvorspannungsgeneratoren erfolgt dies jedoch zeitverzögert, da in diesem Fall nicht ein Pumpen der Ladungspumpe einsetzt, sondern ein langsames Abfließen der gepumpten Ladungen über Leckströme. Bei Anwenden der vorliegenden Erfindung gemäß nachstehender Beschreibung erfolgt diese Anpassung jedoch schnell durch aktives Regeln des Ausgangspotentials VReg:

Der Substratvorspannungsgenerator VBBGen kann eine einfache unkomplizierte Schaltung sein wie z.B. die Hintereinanderschaltung mehrerer Dioden D. Der erfindungsgemäße Potentialgenerator wird nun, entgegen den Ausführungsformen nach den FIG 1 und 2, nicht zwischen den beiden Versorgungspotentiale VCC,VSS der integrierten Halbleiterschaltung angeordnet, sondern zwischen dem anderen Versorgungspotential VSS und dem erzeugten ungeregelten Substratvorspannungspotential VBB. Im Betrieb entsteht als geregeltes Ausgangspotential VReg ein geregeltes Substratvorspannungspotential VBBreg, das wertemäßig zwischen dem anderen Versorgungspotential VSS und dem "On chip" erzeugten ungeregelten Substratvorspannungspotential VBB liegt innerhalb der Grenzen, die durch die Referenzpotentiale V +,V- vorgegeben sind (letztere liegen wertemäßig ebenfalls zwischen dem anderen Versorgungspotential VSS und dem Substratvorspannungspotential VBB). Die Dimensionierung der einzelnen Elemente eines solchen Genera-

4

tors bereitet dem Fachmann anhand der vorstehenden Ausführungen keine Schwierigkeiten.

**Ansprüche**

1. Potentialgenerator in einer integrierten Halbleiterschaltung
- mit einer Generatorschaltung (VGen) zur Erzeugung zweier Referenzpotentiale (V +,V-) mit unterschiedlichen Werten,
- mit einer der Generatorschaltung (VGen) nachgeschalteten Regleranordnung (Reg) und
- mit einer Treiberschaltung (DVR), die der Regleranordnung (Reg) nachgeschaltet ist und an deren Ausgang (K) im Betrieb ein geregeltes Ausgangspotential (VReg) anliegt.
2. Potentialgenerator nach Anspruch 1, **dadurch gekennzeichnet,** daß der Unterschied der Werte der beiden Referenzpotentiale (V +,V-) 50 bis 500 mV beträgt.
3. Potentialgenerator nach Anspruch 1 oder 2, **dadurch gekennzeichnet,** daß das Ausgangspotential (VReg) in einem geregelten Zustand wertemäßig zwischen den Werten der Referenzpotentiale (V +,V-) liegt.
4. Potentialgenerator nach Anspruch 3, dadurch **gekennzeichnet,** daß die Treiberschaltung (DVR) im geregelten Zustand inaktiv geschaltet ist.
5. Potentialgenerator nach einem der vorhergehenden Ansprüche, **dadurch gekennzeichnet,** daß die Generatorschaltung (VGen) wenigstens eine Spannungsteilerschaltung (RV) enthält.
6. Potentialgenerator nach einem der vorhergehenden Ansprüche, **dadurch gekennzeichnet,** daß die Generatorschaltung (VGen) für jedes Referenzpotential (V +,V-) einen Ausgang aufweist.
7. Potentialgenerator nach Anspruch 6, dadurch **gekennzeichnet,** daß zwischen den beiden Ausgängen der Generatorschaltung (VGen) eine Kapazität (C) angeordnet ist.
8. Potentialgenerator nach einem der vorhergehenden Ansprüche, **dadurch gekennzeichnet,**
- daß die Regleranordnung (Reg) zwei Differenzverstärker (Diff1, Diff2) enthält, denen gemeinsam eine Logikschaltung (Log) nachgeschaltet ist,
- daß ein erster Eingang (-) jedes Differenzverstärkers (Diff1, Diff2) jeweils mit einem der Referenzpotentiale (V +,V-) verbunden ist,
- daß auf zweite Eingänge (+) der Differenzverstärker (Diff1, Diff2) das Ausgangspotential (VReg) des Potentialgenerators zurückgekoppelt ist,
- daß ein erster Steuereingang (A) der Logikschaltung (Log) mit dem Ausgang des einen Differenzverstärkers (Diff1) verbunden ist,
- daß ein zweiter Steuereingang (B) der Logikschaltung (Log) mit dem Ausgang des anderen Differenzverstärkers (Diff2) verbunden ist und
- daß zwei Ausgänge (C,D) der Logikschaltung (Log) mit Eingängen der Treiberschaltung (DVR) verbunden sind.
9. Potentialgenerator nach Anspruch 8, **dadurch gekennzeichnet,** daß der Logikschaltung (Log) ein Enable-Signal (EN) zuführbar ist, mittels dessen beide Ausgänge (C,D) der Logikschaltung (Log) deaktivierbar sind.
10. Potentialgenerator nach Anspruch 8 oder 9, **dadurch gekennzeichnet,**
- daß die Logikschaltung (Log) ein NAND-Gatter (NAND) enthält, dessen Eingänge mit den Steuereingängen (A,B) und bei Vorhandensein des Enable-Signals (EN) auch mit diesem verbunden sind und dessen Ausgang der eine Ausgang (C) der Logikschaltung (Log) ist und
- daß die Logikschaltung (Log) ein NOR-Gatter (NOR) enthält, dessen Eingänge mit den Steuereingängen (A,B) und bei Vorhandensein des Enable-Signals (EN) mit einem gegenüber dem Enable-Signal (EN) invertierten Signal verbunden sind und dessen Ausgang der andere Ausgang (D) der Logikschaltung (Log) ist.
11. Potentialgenerator nach Anspruch 10, **dadurch gekennzeichnet,** daß dem NAND-Gatter (NAND) und dem NOR-Gatter (NOR) bezüglich der Eingänge (A,B) der Logikschaltung (Log) jeweils ein Pegelkonverter (CV) vorgeschaltet ist.
12. Potentialgenerator nach einem der vorhergehenden Ansprüche, **dadurch gekennzeichnet,** daß die Treiberschaltung (DVR) wenigstens zwei Transistoren (P,N) enthält, die in Serie zueinander zwischen zwei Versorgungspotentiale (VCC, VSS) der integrierten Halbleiterschaltung geschaltet sind unter Bildung eines gemeinsamen Schaltungsknotens (K), an dem im Betrieb das Ausgangspotential (VReg) des Potentialgenerators entsteht, wobei die Gates der Transistoren (P,N) Eingänge der Treiberschaltung (DVR) sind.
13. Potentialgenerator nach Anspruch 12, **dadurch gekennzeichnet,** daß die Transistoren (P,N) vom zueinander entgegengesetzten Leitungstyp sind.
14. Potentialgenerator nach Anspruch 12 oder 13, **dadurch gekennzeichnet,** daß bei fehlendem Enable-Signal (EN) oder bei aktiviertem Enable-Signal (EN) der eine Transistor (P) elektrisch leitend geschaltet ist, wenn das Ausgangspotential (VReg) niedriger ist als das niedrigere (V-) der beiden Referenzpotentiale (V+,V-) und daß der andere Transistor (N) elektrisch leitend geschaltet ist, wenn das Ausgangspotential (VReg) höher ist als das höhere (V+) der beiden Referenzpotentiale (V+,V-).

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 321 226 (TOSHIBA K.K.) <br> * Spalte 3, Zeile 30 - Spalte 7, Zeile 11; Figuren 3-4 * <br> --- | 1-6,8, 12,13 | G 11 C 5/14 <br> G 11 C 11/407 <br> G 05 F 3/24 |
| A | EP-A-0 205 104 (TOSHIBA K.K.) <br> * Seite 3, Zeile 17 - Seite 5, Zeile 31; Figuren 2,3 * <br> --- | 1-3,5-6 ,12,13 | |
| A | EP-A-0 049 462 (OLYMPUS) <br> * Seite 2, Zeile 30 - Seite 6, Zeile 24; Figur 1 * <br> --- | 1-4,6-8 | |
| A | GB-A-2 180 710 (SGS MICROELETTRONICA S.p.A) <br> * Seite 2, Zeile 105 - Seite 4, Zeile 70; Figuren 5-9 * <br> ----- | 1,8,12, 13 | |

RECHERCHIERTE SACHGEBIETE (Int. Cl.5)

G 11 C 5/00
G 11 C 7/00
G 11 C 11/00
G 05 F 3/00
H 03 F 3/00
H 03 H 11/00

Der vorliegende Recherchenbericht wurde für alle Patentansprüche erstellt

| Recherchenort | Abschlußdatum der Recherche | Prüfer |
|---|---|---|
| DEN HAAG | 04-04-1990 | GEOGHEGAN C.H.B. |